# EUROPÄISCHE PATENTANMELDUNG

(11) **EP 4 675 497 A1**
(43) Veröffentlichungstag der Anmeldung: **07.01.2026**
(21) Anmeldenummer: 24186062.6
(22) Anmeldetag: 02.07.2024
(51) Int. Cl.: G06N 3/0455, G06N 20/00, G01R 31/367, G01R 31/392

(54) **VERFAHREN ZUM BEREITSTELLEN VON REPRÄSENTATIVEN LASTPROFILEN, STEUEREINHEIT UND FAHRZEUG**

(71) Anmelder: VOLKSWAGEN AKTIENGESELLSCHAFT, 38440 Wolfsburg (DE)
(72) Erfinder: Katzschke, Konrad, 10243 Berlin (DE)

(57) **Zusammenfassung**

Die Erfindung betrifft ein Verfahren zum Bereitstellen von repräsentativen Lastprofilen für ein Bauteil (101) eines Fahrzeuges (100),
um eine Auslegung des Bauteils (101) bei einer Entwicklung zu verbessern,
aufweisend:
- Bereitstellen von einem zweiten Modell (B), welches dazu verwendet wird, auf Grundlage von Fahrzeugdaten (FD) oder Repräsentationen (z) von Fahrzeugdaten (FD) für einen zurückliegenden Zeitraum (tr)
- eine Prädiktion (FD*, z*) von Fahrzeugdaten (FD) oder Repräsentationen (z) von Fahrzeugdaten (FD) für einen zukünftigen Zeitraum (tz) zu erstellen und/oder
- eine Reproduktion (FD', z`) von Fahrzeugdaten (FD) oder Repräsentationen (z) von Fahrzeugdaten (FD) für einen zurückliegenden Zeitraum (tr) zu erstellen,

- Verwenden der Prädiktion (FD*, z*) und/oder Reproduktion (FD', z`) für die Auslegung des Bauteils (101).

## Beschreibung

Die Erfindung betrifft ein Verfahren zum Bereitstellen von repräsentativen Lastprofilen für ein Bauteil eines Fahrzeuges, um eine Auslegung des Bauteils bei einer Entwicklung zu verbessern. Ferner betrifft die Erfindung eine korrespondierende Steuereinheit und ein korrespondierendes Fahrzeug.

Jeder Kunde belastet Bauteile mit individueller Intensität. Während der Komponentenentwicklung ist die Berücksichtigung jeder individuellen Nutzungsform a) in Simulationen sehr aufwendig, b) bei realen Experimenten quasi unmöglich.

Manche bekannten Lösungen nutzen repräsentatives Sampling (z. B. WLTC) und/oder Markow-Chain-Ansätze, welche Bauelemente unter der Berücksichtigung einfacher Wahrscheinlichkeitsverteilungen zu einem Gesamtprofil zusammenfügen.

Zumeist werden bei der Bauteilentwicklung nur kurze Fahrphasen berücksichtigt. Oft werden dabei nur zwei Messsignale (i. d. R. Geschwindigkeit v, Beschleunigung a) erfasst.

Es ist daher eine Aufgabe der vorliegenden Erfindung, wenigstens einen der voranstehend beschriebenen Nachteile zumindest teilweise zu überwinden. Insbesondere ist es Aufgabe der Erfindung, ein verbessertes Verfahren zum Bereitstellen von repräsentativen Lastprofilen für ein Bauteil eines Fahrzeuges bereitzustellen, welches dazu dienen kann, die Auslegung des Bauteils bei einer Entwicklung zu verbessern, welches erweiterte Zeiträume für die Auslegung des Bauteils nutzen kann und/oder welches gewünschte Nutzungsprofile erstellen kann. Ferner ist es Aufgabe der Erfindung, eine korrespondierende Steuereinheit und ein korrespondierendes Fahrzeug bereitzustellen.

Die voranstehende Aufgabe wird gelöst durch ein Verfahren mit den Merkmalen des unabhängigen Verfahrensanspruchs sowie durch eine korrespondierende Steuereinheit und ein korrespondierendes Fahrzeug mit den Merkmalen der nebengeordneten Ansprüche. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Steuereinheit und/oder im Zusammenhang mit dem erfindungsgemäßen Fahrzeug und jeweils umgekehrt, sodass bezüglich der Offenbarung zu den einzelnen Erfindungsaspekten stets wechselseitig Bezug genommen wird bzw. werden kann.

### Die Erfindung sieht vor:

Ein Verfahren zum Bereitstellen von repräsentativen (extrapolierten und/oder prognostizierten und/oder gezielt bestimmten) Lastprofilen für ein Bauteil eines Fahrzeuges, um eine Auslegung des Bauteils bei einer Entwicklung zu verbessern, aufweisend:
- Bereitstellen von einem zweiten Modell, welches dazu verwendet wird, auf Grundlage von Fahrzeugdaten oder Repräsentationen von Fahrzeugdaten für einen zurückliegenden Zeitraum
   - eine Prädiktion von Fahrzeugdaten oder Repräsentationen von Fahrzeugdaten für einen zukünftigen Zeitraum zu erstellen und/oder
   - eine Reproduktion von Fahrzeugdaten oder Repräsentationen von Fahrzeugdaten für einen zurückliegenden Zeitraum zu erstellen, und
- Verwenden der Prädiktion und/oder Reproduktion für die Auslegung des Bauteils.

Die Idee liegt dabei in der Nutzung von modernen, modellbasierten Verfahren zum Erstellen von repräsentativen Lastprofilen, um die Auslegung und die Entwicklung von Fahrzeugbauteilen zu verbessern.

Unter Fahrzeugdaten können Messdaten bzw. Sensordaten verstanden werden.

Ein beispielhaftes Bauteil, welches mithilfe von repräsentativen (extrapolierten und/oder prognostizierten und/oder gezielt bestimmten) Lastprofilen ausgelegt und entwickelt werden kann, kann bspw. eine Fahrzeugbatterie sein.

Um die Datenmenge für das zweite Modell (mehrere Jahre * mehrere Fahrzeuge) zu reduzieren, kann ein erstes Modell (A) vorgesehen sein.

Ferner kann, insbesondere vor dem Bereitstellen des zweiten Modelles, das Verfahren vorsehen:
- Bereitstellen von einem ersten Modell, welches dazu verwendet wird, Fahrzeugdaten in eine, insbesondere abstrakte und/oder latente, Repräsentation (bzw. Konfiguration) von Fahrzeugdaten zu komprimieren und/oder die Repräsentation wieder in Fahrzeugdaten zurück zu transformieren.

Eine Datenbasis für das Verfahren kann, wie im Folgenden beschrieben, gewonnen werden:
Vorteilhafterweise kann eine Fahrzeugflotte genutzt werden, bei der Messdaten in einem bestimmten Messzeitraum, bspw. über CAN-Signale von verschiedenen Fahrzeugsensoren, erhoben werden können. Je Fahrzeug dieser Flotte kann demnach eine Historie von Fahrzeugdaten über den einen Messzeitraum erhoben werden. Die Länge jeder Historie (L_{Historie}) kann sich unter den Fahrzeugen unterscheiden. Jede Historie kann in kürzere Abschnitte (L_{Abschnitt}) einer konstanten oder variablen Länge unterteilt werden. Wenn die Länge variabel ist, können unterschiedliche Abschnitte auf dieselbe Länge gebracht werden, bspw. mittels eines (Zero-)Padding-Verfahrens.

Eine Trainingsphase für das erste Modell (A) kann, wie im Folgenden beschrieben, erfolgen:
Das erste Modell kann eine, vorzugsweise abstrakte und/oder latente, Repräsentation bzw. Konfiguration jeder Fahrzeughistorie berechnen. Das erste Modell kann zudem dazu ausgeführt sein, die Repräsentation bzw. Konfiguration wieder in einen Zeitbereich zurückzurechnen. Die Modellparametrierung kann anhand von Flottendaten, bspw. über alle oder eine bestimmte Auswahl an Nutzern, erfolgen, um möglichst viele und/oder ausgewählte Varianten und/oder Nutzerprofile abzubilden.

Jeder Abschnitt (L_{Abschnitt}) der Historie (L_{Historie}) kann in eine latente Dimension (z) überführt werden. Dabei kann z wie folgt gewählt werden: Länge * Anzahl der Signale >> z.

Jede Historie kann demnach als zeitliche Abfolge latenter Komponenten dargestellt werden.

Eine Trainingsphase für das zweite Modell kann, wie im Folgenden beschrieben, erfolgen:
Das zweite Modell kann so gebildet werden, dass es auf Grundlage einer gewissen Rückblickdauer einen nächsten Zeitschritt prädizieren kann.

Das zweite Modell kann als Input zeitliche Abfolgen latenter Repräsentationen oder unverarbeiteten Fahrzeugdaten (gemeint sind Rohsignale) erhalten und auf dieser Grundlage künftige zeitliche Abfolgen latenter Repräsentationen oder Rohsignale prädizieren und/oder reproduzieren.

Durch Rückführung der Prädiktion kann das zweite Modell (B) autoregressiv beliebig viele Zeitschritte in der Zukunft voraussagen.

Die Parametrierung des zweiten Modells kann auf Grundlage aller oder einer bestimmten Auswahl an Flottenfahrzeugen erfolgen.

Das zweite Modell kann ferner mit Eigenschaften eines bestimmten Flottenfahrzeuges konditioniert werden, um die Eigenschaften der Prädiktionen und/oder Reproduktion zu beeinflussen.

Eine Synthetisierungs-Phase kann, wie im Folgenden beschrieben, erfolgen:
Das parametrierte zweite Modell kann dazu genutzt werden, um
- nicht im Feld beobachtete Konditionierungen und/oder Profilausprägungen zu inter/extrapolieren, und/oder
- im Feld beobachtete Konditionierungen und/oder Profilausprägungen verkürzt zu reproduzieren bzw. wiederzugeben, vorzugsweise ohne signifikant an Informationsgehalt zu verlieren.

Wenn das zweite Modell (B) latente Größen prädiziert, kann das erste Modell (A) im weiteren Schritt genutzt werden, um latente Repräsentationen in den Zeitbereich zu übertragen. Die erhaltene Zeitserie kann fortan z. B. für Simulationen oder Prüfstandtests genutzt werden.

Mithilfe des Verfahrens können mehrere Vorteile erreicht werden:
- Berechnen einer kontinuierlichen latenten Dimension, um die Zeitserie zu beschreiben
- Generation von Zeitserien mithilfe von Konditionierung durch entweder abstrakte, latente Komponenten oder menschlich interpretierbare Kennwerte
- Vereinfachung der Zeitserienprädiktion durch Überführung in latente Dimension
- Vorhersage des nächsten Zeitschrittes auf Grundlage eines größeren Lookback-Windows
- Möglichkeit der Modelleinbettung auf einem fahrzeuginternen Steuergerät

Das erste Modell kann bspw., wie im Folgenden beschrieben, realisiert werden:
Option I) Autoencodierendes Neuronales Netz (AE, VAE, ...), welches einen Abschnitt komprimiert.

### Input:

- Abschnitt einer konstanten oder variablen Länge (L_{Abschnitt}) und einer Anzahl D an CAN-Signalen

### Output:

- Abschnitt einer konstanten oder variablen Länge (L_{Abschnitt}) und einer Anzahl D an CAN-Signalen

Das erste Modell A kann den Input durch einen oder mehrere neuronale Layer propagieren. Innerhalb des Netzwerkes wird eine latente Dimension z gebildet ("Bottleneck"). Ein gespiegelter Encoder oder ein Netzwerk mit individueller Architektur, kurz genannt Decoder, kann aus z wieder die ursprüngliche Zeitserie berechnen. z kann (muss aber nicht) reguliert werden, z. B. via "Variationalität/Abbilden auf eine Wahrscheinlichkeitsverteilung", "Codebook", etc. Das Netzwerk kann (muss aber nicht) Denoising-Eigenschaften, wie z. B. stabile Diffusion, aufweisen. Durch Manipulation von z können auch bisher unbeobachtete Ausprägungen der Zeitserien generiert werden.

Option II) Autoregressives neuronales Netz (Transformer, CNN/WaveNet ...), welches eine Zeitserie autoregressiv erzeugt.

### 2 Inputs:

1) Konditionierung z mit den gewünschten Eigenschaften
2) Zeitserie mit Länge tr (Rückblick) und D Signalen

### 1 Output:

Zeitserie mit D Signalen für die Zeitserie mit Länge tz (Zukunft)

Über die Konditionierung 1) können Eigenschaften der erzeugten Zeitserie beeinflusst werden. Die Konditionierung kann entweder menschlich interpretierbar (z. B. Histogramme über Messgrößen) oder abstrakt (von Netzwerk erlernte, encodierte Repräsentation einer Zeitserie) sein. Beispielweise können Werte aus bereits vorhandenen Historiendaten genutzt werden.

Beispiele: Länge des gewünschten Profils, Wh/km; km/Tag; DC-Ladeanteil, SoC-Anteile während Fahrbetrieb usw.

Input 2) kann anfangs initialisiert werden, z. B. mit Nullen. Autoregressiv kann diese Initialisierung dann erweitert werden, bis ein Endkriterium eintritt wird, z. B. bis die gewünschte Länge erreicht wird.

Das zweite Modell (B) kann bspw., wie im Folgenden beschrieben, realisiert werden:
Autoregressives neuronales Netz (Transformer, CNN/WaveNet ...), welches eine Zeitserie autoregressiv erzeugt.

### 2 Inputs:

1) Konditionierung z mit den gewünschten Eigenschaften
2) Zeitserie mit Länge tr (Rückblick) und D Signalen oder
Zeitserie mit Länge tr (Rückblick) und z Dimensionen.

### 1 Output:

Zeitserie mit Länge tz (Zukunft) und D Signalen oder
Zeitserie mit Länge tz (Zukunft) und z Dimensionen.

Das zweite Modell kann außerdem oder stattdessen das Nutzungsverhalten über längere Zeiträume wiedergeben.

Um die Prädiktionsaufgabe zu vereinfachen und/oder die Rechenzeit zu beschleunigen, können die Prädiktionen auch auf latente Komponenten erfolgen, die mithilfe des ersten Modells erstellt werden können.

Bei dem zweiten Modell (B) ist außerdem oder alternativ eine Nutzung von regressiven Verfahren denkbar, wie z. B. Support Vector Regression, Random Forest Regression, Prophet usw.

Mit anderen Worten können mithilfe des Verfahrens folgende Vorteile erzielt werden:
- Mehrere korrelierende Dimensionen mit angemessenem Rechenaufwand sind synthetisierbar
- Nicht beobachtete Ausprägungen können generativ erzeugt und über Konditionierung detailliert gesteuert werden
- Reihenfolge & Trends über lange Zeiträume sind deutlich besser abgedeckt als bei klassischen Ansätzen
- Kontinuierliche Prädiktionen sorgen für höhere Genauigkeit & Konsistenz zwischen den Dimensionen
- Parametrierung kann kontinuierlich aktualisiert werden, ggf. auch direkt auf dem Fahrzeug in einer entsprechenden Steuereinheit

Wie oben bereits erwähnt, kann das zweite Modell mithilfe von Fahrzeugdaten und/oder von Repräsentationen parametriert und/oder trainiert werden. Je nachdem, wie groß die Datenmenge ist, kann somit eine geeignete Parametrierung bzw. ein geeignetes Training mit allen oder nur mit komprimierten Daten durchgeführt werden.

Wie oben bereits erwähnt, kann das erste Modell dazu verwendet werden, durch Rückführung der Prädiktion zukünftige Fahrzeugdaten vorauszusagen, wobei insbesondere die zukünftigen Fahrzeugdaten für die Auslegung des Bauteils verwendet werden. Im Falle, wenn das zweite Modell komprimierte Daten voraussagt und/oder reproduziert, kann das erste Modell dazu dienen, diese Daten in echte Zeitserien von Fahrzeugdaten zu transformieren.

Vorteilhafterweise können die Fahrzeugdaten mehrere Messdaten (bzw. Sensorsignale unterschiedlicher Fahrzeugsensoren) an dem Bauteil umfassen, wie bspw. Leistung, Temperatur und/oder Ladezustand einer Fahrzeugbatterie und/oder eine Fahrzeuggeschwindigkeit.

Ferner ist es denkbar, dass eine Parametrierung und/oder ein Training des ersten Modells und/oder des zweiten Modells anhand von Flottendaten durchgeführt wird. Die Flottendaten können bspw. Fahrzeugdaten von mehreren Fahrzeugen oder einer bestimmten Auswahl an Fahrzeugen umfassen, um vorzugsweise verschiedene Nutzungsprofile abzubilden.

Vorteilhafterweise kann eine Konditionierung des ersten Modells und/oder des zweiten Modells nach Nutzungstyp durchgeführt werden, um insbesondere gewünschte Nutzungsprofile zu generieren.

Wie oben bereits erwähnt, kann das erste Modell ein autoencodierendes neuronales Netz (AE, VAE ...) verwenden.

Ferner kann das erste Modell ein autoregressives neuronales Netz (Transformer, CNN/WaveNet ...) verwenden.

Grundsätzlich kann das erste Modell ein Denoising-Verfahren verwenden.

Wie oben bereits erwähnt, kann das zweite Modell ein autoregressives neuronales Netz (Transformer, CNN/WaveNet ...) verwenden.

Ferner kann das zweite Modell ein regressives Verfahren (Support Vector Regression, Random Forest Regression, Prophet ...) verwenden.

Vorteilhafterweise kann das zweite Modell die Prädiktion autoregressiv verwenden. Auf diese Weise können beliebig viele Zeitschritte in der Zukunft vorausgesagt werden.

Die obenstehende Aufgabe wird weiterhin gelöst durch:
eine Steuereinheit, aufweisend mindestens eine Speichereinheit, in welcher ein erstes Modell und/oder ein zweites Modell hinterlegt ist, welches durch ein Verfahren parametriert und/oder trainiert wurde, welches wie oben beschrieben ablaufen kann. Dabei können die gleichen Vorteile erzielt werden, die oben im Zusammenhang mit dem erfindungsgemäßen Verfahren beschrieben worden sind.

Ferner ist es denkbar, dass eine Parametrierung des ersten Modells und/oder des zweiten Modells durch ein externes Update und/oder im laufenden Betrieb eines Fahrzeuges fahrzeugseitig aktualisierbar sein kann.

Die obenstehende Aufgabe wird weiterhin gelöst durch:
ein Fahrzeug, aufweisend eine Steuereinheit, welche wie oben beschrieben ausgeführt sein kann. Dabei können die gleichen Vorteile erzielt werden, die oben im Zusammenhang mit dem erfindungsgemäßen Verfahren beschrieben worden sind.

Weitere Vorteile und Merkmale der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei zeigen jeweils schematisch:
- Figur 1: beispielhafte Fahrzeugdaten bzw. Sensorsignale,
- Figur 2: eine beispielhafte Ausführung eines ersten Modells,
- Figur 3: eine beispielhafte Ausführung eines ersten Modells und
- Figur 4: eine beispielhafte Ausführung eines zweiten Modells.

In den nachfolgenden Figuren werden für die gleichen technischen Merkmale, auch von unterschiedlichen Ausführungsbeispielen, die identischen Bezugszeichen verwendet.

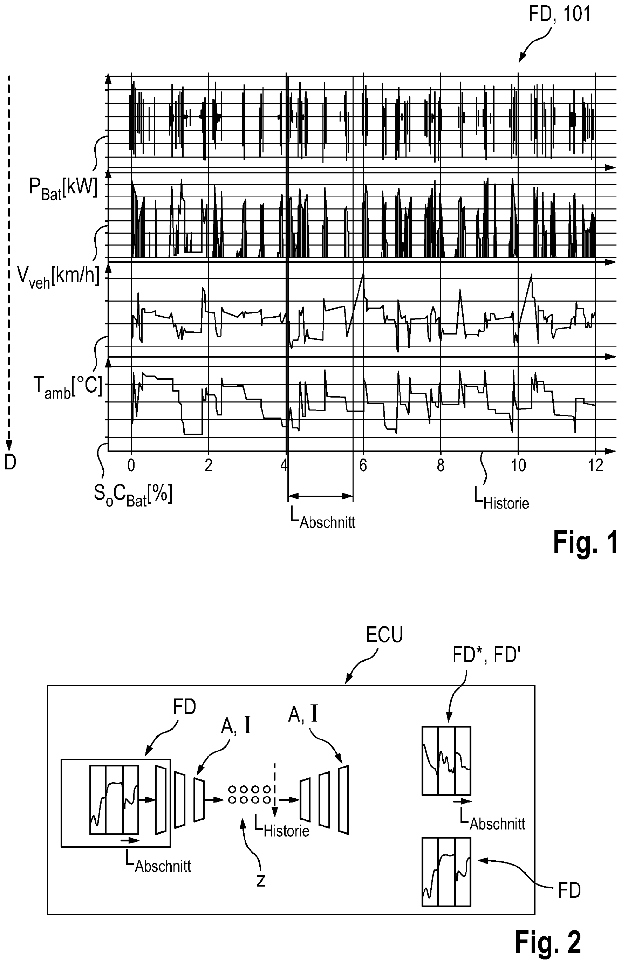

Die Fig. 1 bis 4 dienen zum Erklären eines vorgeschlagenen Verfahrens, welches zum Bereitstellen von repräsentativen (extrapolierten und/oder prognostizierten und/oder gezielt bestimmten) Lastprofilen für ein Bauteil 101 eines Fahrzeuges 100 entwickelt wurde, um eine Auslegung des Bauteils 101 bei einer Entwicklung zu verbessern.

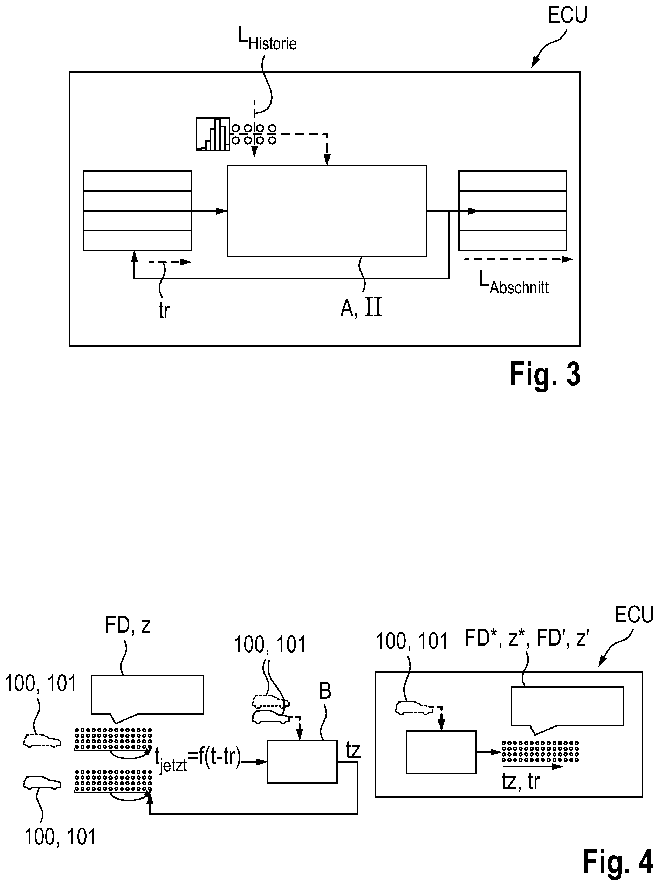

Wie es Fig. 4 andeutet, sieht das Verfahren vor:
- Bereitstellen von einem zweiten Modell B, welches dazu verwendet wird, auf Grundlage von Fahrzeugdaten FD oder Repräsentationen z von Fahrzeugdaten FD für einen zurückliegenden Zeitraum tr
   - eine Prädiktion FD*, z* von Fahrzeugdaten FD (vgl. Fig. 1) oder Repräsentationen z (vgl. Fig. 2) von Fahrzeugdaten FD für einen zukünftigen Zeitraum tz zu erstellen und/oder
   - eine Reproduktion FD', z` von Fahrzeugdaten FD (vgl. Fig. 1) oder Repräsentationen z (vgl. Fig. 2) von Fahrzeugdaten FD für einen zurückliegenden Zeitraum tr zu erstellen, und
- Verwenden der Prädiktion FD*, z* und/oder Reproduktion FD', z` für die Auslegung des Bauteils 101.

Die Idee liegt dabei in der Nutzung von modernen, modellbasierten Verfahren zum Erstellen von repräsentativen Lastprofilen, um die Auslegung und die Entwicklung von Fahrzeugbauteilen zu verbessern.

Unter Fahrzeugdaten FD können Messdaten bzw. Sensordaten verstanden werden.

Ein Bauteil, welches mithilfe von repräsentativen (extrapolierten und/oder prognostizierten und/oder gezielt bestimmten) Lastprofilen ausgelegt und entwickelt werden kann, kann bspw. eine Fahrzeugbatterie sein.

Um die Datenmenge für das zweite Modell B (bspw. mehrere Jahre * mehrere [Flotten-]Fahrzeuge) zu reduzieren, kann ein erstes Modell A (vgl. Fig. 2 oder 3) vorgesehen sein.

Wie es die Fig. 2 und 3 andeuten, kann, insbesondere vor dem Bereitstellen des zweiten Modelles B, das Verfahren vorsehen:
- Bereitstellen von einem ersten Modell A, welches dazu verwendet wird, Fahrzeugdaten FD in eine, insbesondere abstrakte und/oder latente, Repräsentation z (bzw. Konfiguration) von Fahrzeugdaten FD zu komprimieren und/oder die Repräsentation z wieder in Fahrzeugdaten FD zurück zu transformieren.

Vorteilhafterweise kann eine Fahrzeugflotte genutzt werden, bei der Messdaten in einem bestimmten Messzeitraum, bspw. über CAN-Signale von verschiedenen Fahrzeugsensoren, erhoben werden können. Je Fahrzeug dieser Flotte kann demnach eine Historie von Fahrzeugdaten FD über den einen Messzeitraum erhoben werden. Die Länge jeder Historie L_{Historie} kann sich unter den Fahrzeugen unterscheiden. Jede Historie kann in kürzere Abschnitte L_{Abschnitt} einer konstanten oder variablen Länge unterteilt werden. Wenn die Länge variabel ist, können unterschiedliche Abschnitte auf dieselbe Länge gebracht werden, bspw. mittels eines (Zero-)Padding-Verfahrens.

### Trainingsphase für das erste Modell A:

Das erste Modell A kann eine, vorzugsweise abstrakte und/oder latente, Repräsentation bzw. Konfiguration jeder Fahrzeughistorie berechnen. Das erste Modell A kann zudem dazu ausgeführt sein, die Repräsentation bzw. Konfiguration wieder in einen Zeitbereich zurückzurechnen. Die Modellparametrierung kann anhand von Flottendaten, bspw. über alle oder eine bestimmte Auswahl an Nutzern, erfolgen, um möglichst viele und/oder ausgewählte Varianten und/oder Nutzerprofile abzubilden.

Jeder Abschnitt L_{Abschnitt} der Historie L_{Historie} (vgl. Fig. 1) an Fahrzeugdaten FD (bzw. Messsignalen) kann in eine latente Dimension z überführt werden, wie es die Fig. 2 andeutet.

Dabei kann z wie folgt gewählt werden: Länge * Anzahl der Signale >> z.

Jede Historie L_{Historie} an Fahrzeugdaten FD kann demnach als zeitliche Abfolge latenter Repräsentationen z dargestellt werden.

### Eine Trainingsphase für das zweite Modell B:

Das zweite Modell B kann so gebildet werden, dass es auf Grundlage einer gewissen Rückblickdauer eines zurückliegenden Zeitraums tr einen nächsten Zeitschritt für einen zukünftigen Zeitraum tz prädizieren kann.

Das zweite Modell B kann als Input zeitliche Abfolgen latenter Repräsentationen z oder unverarbeitete Fahrzeugdaten FD (gemeint sind Rohsignale) erhalten und auf dieser Grundlage künftige zeitliche Abfolgen latenter Repräsentationen z oder Rohsignale prädizieren oder reproduzieren.

Durch Rückführung der Prädiktion z kann das zweite Modell B autoregressiv beliebig viele Zeitschritte in der Zukunft voraussagen.

Wie es die Fig. 4 links andeutet, kann die Parametrierung des zweiten Modells B auf Grundlage aller oder einer bestimmten Auswahl an Flottenfahrzeugen erfolgen. Das zweite Modell B kann dabei mit Eigenschaften eines bestimmten Flottenfahrzeuges konditioniert werden, um die Eigenschaften der Prädiktion FD*, z* und/oder Reproduktion FD', z' zu beeinflussen.

Eine Synthetisierungs-Phase kann, wie es die Fig. 4 rechts andeutet, erfolgen:
Das parametrierte zweite Modell B kann dazu genutzt werden, um
- nicht im Feld beobachtete Konditionierungen und/oder Profilausprägungen zu inter/extrapolieren und/oder
- im Feld beobachtete Konditionierungen und/oder Profilausprägungen verkürzt zu reproduzieren bzw. wiederzugeben, vorzugsweise ohne signifikant an Informationsgehalt zu verlieren.

Wenn das zweite Modell B latente Größen prädiziert, kann das erste Modell A im weiteren Schritt genutzt werden, um latente Repräsentationen z wieder in den Zeitbereich zu übertragen. Die erhaltene Zeitserie kann fortan z. B. für Simulationen oder Prüfstandtests für die Entwicklung des Bauteils 101 genutzt werden.

Mithilfe des Verfahrens können mehrere Vorteile erreicht werden:
- Berechnen einer kontinuierlichen latenten Dimension, um die Zeitserie zu beschreiben
- Generation von Zeitserien mithilfe von Konditionierung durch entweder abstrakte, latente Komponenten oder menschlich interpretierbare Kennwerte
- Vereinfachung der Zeitserienprädiktion durch Überführung in latente Dimension
- Vorhersage des nächsten Zeitschrittes auf Grundlage eines größeren Lookback-Windows
- Möglichkeitder Modelleinbettung auf einem fahrzeuginternen Steuergerät

Das erste Modell A kann bspw., wie im Folgenden beschrieben, realisiert werden:
Option I, die in der Fig. 2 gezeigt ist: autoencodierendes Neuronales Netz (AE, VAE ...), welches einen Abschnitt komprimiert.

### Input:

- Abschnitt einer konstanten oder variablen Länge L_{Abschnitt} und einer Anzahl D an CAN-Signalen

### Output:

- Abschnitt einer konstanten oder variablen Länge L_{Abschnitt} und einer Anzahl D an CAN-Signalen

Das erste Modell A kann den Input durch einen oder mehrere neuronale Layer propagieren. Innerhalb des Netzwerkes wird eine latente Dimension z gebildet ("Bottleneck"). Ein gespiegelter Encoder oder ein Netzwerk mit individueller Architektur, kurz genannt Decoder, kann aus z wieder die ursprüngliche Zeitserie berechnen. z kann (muss aber nicht) reguliert werden, z. B. via "Variationalität/Abbilden auf eine Wahrscheinlichkeitsverteilung", "Codebook", etc. Das Netzwerk kann (muss aber nicht) Denoising-Eigenschaften, wie z. B. stabile Diffusion, aufweisen. Durch Manipulation von z können auch bisher unbeobachtete Ausprägungen der Zeitserien generiert werden.

Option II, die in der Fig. 3 gezeigt ist: autoregressives Neuronales Netz (Transformer, CNN/WaveNet ...), welches eine Zeitserie autoregressiv erzeugt.

### 2 Inputs:

1) Konditionierung z mit den gewünschten Eigenschaften
2) Zeitserie mit Länge tr (Rückblick) und D Signalen

### 1 Output:

Zeitserie mit D Signalen für die Zeitserie mit Länge tz (Zukunft)

Über die Konditionierung 1) können Eigenschaften der erzeugten Zeitserie beeinflusst werden. Die Konditionierung kann entweder menschlich interpretierbar (z. B. Histogramme über Messgrößen) oder abstrakt (von Netzwerk erlernte, encodierte Repräsentation einer Zeitserie) sein. Beispielweise können Werte aus bereits vorhandenen Historiendaten genutzt werden.

Beispiele: Länge des gewünschten Profils, Wh/km; km/Tag; DC-Ladeanteil, SoC-Anteile während Fahrbetrieb usw.

Input 2) kann anfangs initialisiert werden, z. B. mit Nullen. Autoregressiv kann diese Initialisierung dann erweitert werden, bis ein Endkriterium eintritt wird, z. B. bis die gewünschte Länge erreicht wird.

Das zweite Modell B kann bspw., wie in Fig. 4 angedeutet ist, realisiert werden:
Autoregressives neuronales Netz (Transformer, CNN/WaveNet ...), welches eine Zeitserie autoregressiv erzeugt.

### 2 Inputs:

1) Konditionierung z mit den gewünschten Eigenschaften
2) Zeitserie mit Länge tr (Rückblick) und D Signalen oder
Zeitserie mit Länge tr (Rückblick) und z Dimensionen

### 1 Output:

Zeitserie mit Länge tz (Zukunft) und D Signalen oder
Zeitserie mit Länge tz (Zukunft) und z Dimensionen

Das zweite Modell B kann außerdem oder stattdessen das Nutzungsverhalten über längere Zeiträume wiedergeben.

Um die Prädiktionsaufgabe zu vereinfachen und/oder die Rechenzeit zu beschleunigen, können die Prädiktionen FD*, z* auch auf latente Komponenten z erfolgen, die mithilfe des ersten Modells A erstellt werden können.

Bei dem zweiten Modell B ist außerdem oder alternativ eine Nutzung von regressiven Verfahren denkbar, wie z. B. Support Vector Regression, Random Forest Regression, Prophet usw.

Mit anderen Worten können mithilfe des Verfahrens folgende Vorteile erzielt werden:
- Mehrere korrelierende Dimensionen mit angemessenem Rechenaufwand sind synthetisierbar
- Nicht beobachtete Ausprägungen können generativ erzeugt und über Konditionierung detailliert gesteuert werden
- Reihenfolge & Trends über lange Zeiträume sind deutlich besser abgedeckt als bei klassischen Ansätzen
- Kontinuierliche Prädiktionen sorgen für höhere Genauigkeit & Konsistenz zwischen den Dimensionen
- Parametrierung kann kontinuierlich aktualisiert werden, ggf. auch direkt auf dem Fahrzeug in einer entsprechenden Steuereinheit

Eine korrespondierende Steuereinheit ECU und ein korrespondierendes Fahrzeug 100 stellen ebenfalls Aspekte der Erfindung dar.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 100: Fahrzeug
- 101: Bauteil
- ECU: Steuereinheit

- A: Modell

- I: Option
- II: Option

- z: Repräsentation

- FD: Fahrzeugdaten/Messdaten/Sensorsignale

- B: Modell

- FD*, z*: Prädiktion
- FD*: zukünftige Fahrzeugdaten

- FD', z`: Reproduktion
- FD`: reproduzierte Fahrzeugdaten

- L_{Abschnitt}: Abschnitt von Fahrzeugdaten

- t_{Historie}: Historie von Fahrzeugdaten

- tz: zukünftiger Zeitraum

- tr: zurückliegender Zeitraum

## Patentansprüche

1. Verfahren zum Bereitstellen von repräsentativen Lastprofilen für ein Bauteil (101) eines Fahrzeuges (100),
um eine Auslegung des Bauteils (101) bei einer Entwicklung zu verbessern, aufweisend:
- Bereitstellen von einem zweiten Modell (B), welches dazu verwendet wird, auf Grundlage von Fahrzeugdaten (FD) oder Repräsentationen (z) von Fahrzeugdaten (FD) für einen zurückliegenden Zeitraum (tr)
- eine Prädiktion (FD*, z*) von Fahrzeugdaten (FD) oder Repräsentationen (z) von Fahrzeugdaten (FD) für einen zukünftigen Zeitraum (tz) zu erstellen und/oder
- eine Reproduktion (FD', z`) von Fahrzeugdaten (FD) oder Repräsentationen (z) von Fahrzeugdaten (FD) für einen zurückliegenden Zeitraum (tr) zu erstellen,
- Verwenden der Prädiktion (FD*, z*) und/oder Reproduktion (FD', z`) für die Auslegung des Bauteils (101).

2. Verfahren nach Anspruch 1,
ferner aufweisend, insbesondere vor dem Bereitstellen des zweiten Modelles (B):
- Bereitstellen von einem ersten Modell (A), welches dazu verwendet wird, Fahrzeugdaten (FD) in eine, insbesondere abstrakte und/oder latente, Repräsentation (z) von Fahrzeugdaten (FD) zu komprimieren und/oder die Repräsentation (z) wieder in Fahrzeugdaten (FD) zurück zu transformieren.

3. Verfahren nach Anspruch 1 oder 2,
wobei das zweite Modell (B) mithilfe von Fahrzeugdaten (FD) und/oder von Repräsentationen (z) parametriert und/oder trainiert wird.

4. Verfahren nach einem der vorhergehenden Ansprüche 2 oder 3,
wobei das erste Modell (A) dazu verwendet wird, durch Rückführung der Prädiktion (FD*, z*) zukünftige Fahrzeugdaten (FD*) vorauszusagen,
wobei insbesondere die zukünftigen Fahrzeugdaten (FD*) für die Auslegung des Bauteils (101) verwendet werden.

5. Verfahren nach einem der vorhergehenden Ansprüche,
wobei die Fahrzeugdaten (FD) mehrere Messdaten an dem Bauteil (101) umfassen, wie bspw. Leistung (P), Temperatur (T) und/oder Ladezustand (SoC) einer Fahrzeugbatterie,
und/oder eine Fahrzeuggeschwindigkeit (v).

6. Verfahren nach einem der vorhergehenden Ansprüche,
wobei eine Parametrierung und/oder ein Training des ersten Modells (A) und/oder des zweiten Modells (B) anhand von Flottendaten durchgeführt wird,
wobei insbesondere die Flottendaten Fahrzeugdaten (FD) von mehreren Fahrzeugen oder einer bestimmten Auswahl an Fahrzeugen umfassen,
um vorzugsweise verschiedene Nutzungsprofile abzubilden.

7. Verfahren nach einem der vorhergehenden Ansprüche,
wobei eine Konditionierung des ersten Modells (A) und/oder des zweiten Modells (B) nach Nutzungstyp durchgeführt wird,
um insbesondere gewünschte Nutzungsprofile zu generieren.

8. Verfahren nach einem der vorhergehenden Ansprüche,
wobei das erste Modell (A) ein autoencodierendes neuronales Netz verwendet,
und/oder wobei das erste Modell (A) ein autoregressives neuronales Netz verwendet,
und/oder wobei das erste Modell (A) ein Denoising-Verfahren verwendet.

9. Verfahren nach einem der vorhergehenden Ansprüche,
wobei das zweite Modell (B) ein autoregressives neuronales Netz verwendet,
und/oder wobei das zweite Modell (B) ein regressives Verfahren verwendet.

10. Verfahren nach einem der vorhergehenden Ansprüche,
wobei das zweite Modell (B) die Prädiktion (FD*, z*) autoregressiv verwendet.

11. Steuereinheit (ECU), aufweisend mindestens eine Speichereinheit, in welcher ein erstes Modell (A) und/oder ein zweites Modell (B) hinterlegt ist, welches durch ein Verfahren nach einem der vorhergehenden Verfahrensansprüche parametriert und/oder trainiert wurde.

12. Steuereinheit (ECU) nach dem vorhergehenden Anspruch,
wobei eine Parametrierung des ersten Modells (A) und/oder des zweiten Modells (B) durch ein externes Update und/oder im laufenden Betrieb eines Fahrzeuges fahrzeugseitig aktualisierbar ist.

13. Fahrzeug (100), aufweisend eine Steuereinheit (ECU) nach einem der vorhergehenden Ansprüche 11 oder 12.
